# EUROPÄISCHE PATENTSCHRIFT

(11) **EP 1 983 399 B1**
(45) Veröffentlichungstag und Bekanntmachung des Hinweises auf die Patenterteilung: **28.10.2015**
(21) Anmeldenummer: 07464002.0
(22) Anmeldetag: 20.04.2007
(51) Int. Cl.: G06F 1/025, H03K 7/08

(54) **PDM-Steuerkanalerweiterung**
PWM control channels extension
Extension des canaux de réglage à modulation de largeur d'impulsion

(43) Veröffentlichungstag der Anmeldung: 22.10.2008
(73) Patentinhaber: Continental Automotive GmbH, 30165 Hannover (DE)
(72) Erfinder: Botoaca, Andrei, 300125 Timisoara (RO)

(56) Entgegenhaltungen:
- WO-A-93/23912
- DE-A1- 19 620 207
- US-A- 5 248 900
- US-A- 5 793 808
- US-A- 6 094 079
- US-A1- 2004 207 466
- MICHAEL DAY: "PWM dimming enhances color purity in high-end LED video displays" EETIMES EUROPE ONLINE, [Online] 31. Oktober 2005 (2005-10-31), Seiten 1-2, XP002456004 Gefunden im Internet: URL:http://eetimes.eu/173401243?pgno=2> [gefunden am 2007-10-22]
- ANDY GAYNE: "AVR136: Low-Jitter Multi-Channel Software PWM, Rev. 8020A-AVR-05/06"[Online] Mai 2006 (2006-05), Seiten 1-5, XP002456005 Gefunden im Internet: URL:http://www.atmel.com/dyn/resources/pro d_documents/doc8020.pdf> [gefunden am 2007-10-22]

## Beschreibung

Die Erfindung betrifft die Steuerung Licht emittierender Einrichtungen in Kraftfahrzeugen und bezieht sich im Besonderen auf die Erweiterung der von einem Mikrosteuerbaustein in einem Karosseriesteuergerät verfügbaren Hardware Kanäle zur pulsdauermodulierten Ansteuerung von Licht- und Beleuchtungseinrichtungen.

Zur Verbesserung der Sicherheit und des Komforts von Kraftfahrzeugen werden zunehmend so genannte Karosseriesteuergeräte (englisch: Body Control Unit; abgek. BCU) eingesetzt, die bestimmte Funktionen des Fahrzeugs, wie z.B. die als Airbag bezeichneten Prallkissen, Klimaanlage, Scheibenwischer, Zugangssysteme, Schiebedach und vor allem auch die internen und externen Beleuchtungsanlagen steuern. Karosseriesteuergeräte vereinen im Allgemeinen mehrere Funktionen in einem Gehäuse und umgekehrt sind üblicherweise mehrere dieser Geräte im Fahrzeug verteilt angeordnet.

Karosseriesteuergeräte sind in der Regel modular aufgebaut, leicht anpassbar und ermöglichen die Integration verschiedener Steuerungsfunktionen auf kleinstem Raum. Mittels der durch sie möglichen Reduzierung der Steckverbinder und Kabelbäume im Fahrzeug bieten sie ein Höchstmaß an Zuverlässigkeit und Wirtschaftlichkeit.

Gewöhnlich enthält ein Karosseriesteuergerät zumindest zwei Untereinheiten, ein Logikmodul und ein Leistungsmodul. Das Logikmodul besitzt meist die Funktionalität eines programmierbaren Knotens, während das Leistungsmodul die einzelnen Verbraucher des Fahrzeugs entsprechend den Vorgaben des Logikmoduls steuert. Zur Steuerung der Beleuchtungsanlagen eines Kraftfahrzeugs werden die Steuersignale an die entsprechenden Einheiten, meist Leistungstransistoren oder dergleichen des Leistungsmoduls übertragen, die dann die eigentliche Steuergröße, beispielsweise die Versorgungsspannung oder den Versorgungsstrom, der jeweiligen lichttechnischen Einrichtung auf der Grundlage dieser Steuersignale erzeugen.

Die Beleuchtungsanlage von Kraftfahrzeugen umfasst im Allgemeinen Schaltungsabschnitte für die Fahrzeugscheinwerfer, die Signalleuchten des Fahrzeugs, wie z.B. die Heckleuchten, Fahrtrichtungs- und Warnanzeiger, sowie die Innenraum- und Instrumentenbeleuchtung. Zur Verbesserung der elektromagnetischen Verträglichkeit (EMV) des Bordnetzes, insbesondere im Hinblick auf die Funkentstörung, aber auch zur Erhöhung der Zuverlässigkeit und Lebensdauer der Beleuchtungseinrichtungen, wird die zum Betrieb der Leuchtmittel erforderliche Versorgungsspannung nicht unmittelbar an diese angelegt. Stattdessen wird eine pulsdauermodulierte (PDM) Versorgungsspannung verwendet, wodurch sich schädliche Überspannungsspitzen vermeiden lassen und die fehleranfällige Übertragung geringer Spannungen bei reduzierter Lichtemission umgangen wird.

Die Pulsdauermodulation der Versorgungsspannung für Leuchtmittel ermöglicht einerseits das langsame Hochfahren der effektiven Versorgungsspannung für z.B. die Scheinwerferlampen eines Fahrzeugs, wodurch sich die Lebensdauer dieser Leuchtmittel beträchtlich erhöht; andererseits kann damit auch der zeitliche Verlauf der Lichtemission von Leuchtmitteln, wie beispielsweise in Blinkern oder in an die Umgebungshelligkeit angepassten Instrumenten- oder Armaturenbrettbeleuchtungen zuverlässig gesteuert werden.

Hierzu wird in der logischen Untereinheit des Karosseriesteuergeräts üblicherweise ein als integrierter Schaltkreis ausgebildeter Mikrosteuerbaustein verwendet, der eine je nach Bauart unterschiedliche Anzahl von über die Hardware (HW) des Bausteins pulsdauermodulierten Ausgängen besitzt. Gegenwärtig werden in Karosseriesteuergeräten als MCUs (von englisch microcontroller unit) bezeichnete Mikrosteuerbausteine mit 4, 6 oder 8 dieser so genannten HW-PDM-Kanäle verwendet. Parameter der über diese Kanäle implementierten Pulsdauermodulation sind die Frequenz der Impulse und deren Tastverhältnis bzw. Füllfaktor, d.h. das Verhältnis der jeweiligen Pulsdauer zur Periodendauer eines PDM-Signals. Hierzu müssen pro Kanal zwei Timer (Zeitgeber) der MCUs verwendet werden: ein Timer zur Regelung der Frequenz und ein Timer zur Steuerung des Füllfaktors.

In diesem Zusammenhang sei darauf verwiesen, dass, sofern im Einzelnen nicht explizit anders angegeben, in dieser Schrift durchgehend und abweichend vom deutschen Sprachgebrauch der Begriff 'steuern' gleichbedeutend mit dem Begriff 'regeln' verwendet wird. Dies betrifft auch alle grammatikalischen Abwandlungen beider Begriffe. In dieser Schrift kann der Begriff 'Steuerung' daher ebenso eine Rückführung einer Regelgröße bzw. deren Messwerts umfassen, wie sich der Begriff 'Regelung' auf eine einfache Steuerkette beziehen kann.

Werden alle HW-PDM-Kanäle der MCU verwendet, sind in der Regel keine Timer mehr für andere Aufgaben des Karosseriesteuergeräts frei. Ferner reicht die Anzahl der HW-PDM-Kanäle einer MCU in der Regel nicht aus, um die Steuerung aller von einem es enthaltenden Karosseriesteuergerät versorgten Leuchtmittel zu gewährleisten. Die Verwendung mehrer MCUs in einem Karosseriesteuergerät ist wirtschaftlich jedoch nicht vertretbar.

Bei dem in der US 5 793 808 vorgestellten System werden von Sensoren während eines Abtastzeitraums erfasste Parameter von einem Prozessor als Sensorsignale über Eingangskanäle gelesen und mit Zielwerten verglichen. Aus dem Vergleich bestimmt der Prozessor für jeden Kanal eines PDM-Signals ein bestimmtes Tastverhältnis.

Aus dem Tastverhältnis ergibt sich für den jeweiligen Kanal ein bestimmtes Verhältnis von Ein- zu Auszeit. Eine Änderung von einem Kanalzustand in einen anderen erfolgt nur bei einem Übergang von einem Taktzyklus zum nächsten.

Innerhalb eines Taktzyklus' (z.B. A2 mit (t1+t2)/2 < t < (t2+t1)) werden die Zustände aller Kanäle zusammen in Form eines digitalen Worts angegeben, so dass man eine Kodierung der Tastverhältnisse aller Kanäle als Serie digitaler Wörter erhält. Jedes einzelne der Wörter ist für genau einen Taktzyklus gültig. Jedes einzelne Bit eines solchen Worts ist dabei jeweils genau einem der Kanäle zugeordnet. Sein jeweiliger Wert (0/1) bestimmt den gewünschten Zustand (An/Aus) dieses Kanals während des entsprechenden Taktzyklus'. Die einzelnen, dem Schaltzustand aller Kanäle zu den jeweiligen Taktzyklen entsprechenden Wörter werden in der gewünschten chronologischen Reihenfolge in aneinandergrenzende Speicherplätze eines RAMs geschrieben.

Aus diesem RAM werden die digitalen Wörter von einem DMA der Reihe nach ausgelesen und in den Ausgang des DMA geschrieben. Hat das DMA das letzte Wort erreicht, so erhält es vom Prozessor die Anweisung, die ausgelesene Sequenz zu wiederholen. Das DMA wiederholt die Wortsequenz bis zum nächsten Abtastzeitraum, bei dem die im RAM gespeicherte Wortfolge unter Verwendung der nun neu abgetasteten Sensorwerte aktualisiert wird. Die Steuerung der Aktoren erfolgt mittels Haltegliedern, die die jeweiligen Ausgänge des DMA bis zum jeweils nächsten Taktzyklus (der Zeitpunkt der Gültigkeit des nächsten Wortes) der Impulsbreitenmodulation aufrechterhalten.

Um Stromspitzen zu vermeiden sollen bei einer der beschriebenen Ausführungsform nicht alle Kanäle gleichzeitig eingeschaltet werden. Um dies zu erreichen, werden die Kanäle in Gruppen eingeteilt, wobei bei einer Gruppe von Kanälen die "Aus"-Zeiten den "Ein"-Zeiten vorangehen, während bei der anderen Gruppe in umgekehrter Weise die "Ein"-Zeiten den "Aus"-Zeiten vorangehen. Ein angegebenes Beispiel veranschaulicht, wie hierdurch die Strombelastung über einen Abtastzeitraum egalisiert werden kann.

Die Schrift WO 93/23912 ist mit einer programmierbaren Impulsweitenmodulation (PWM) zur Steuerung eines Inverters (Gleichstrom-Drehstrom-Konverter) befasst. Die Steuerung erfolgt mittels so genannter gating signals, die die Schaltzustände der im Inverter befindlichen Schaltelemente steuern. Die von der PWM-Steuerung hierzu ausgegebene Gruppe von gating signals wird als driveword bezeichnet. Mit dem driveword zusammen wird eine sogenannte drivetime ausgegeben, die angibt, wann das driveword nicht mehr aktuell sein wird. Dadurch muss nicht für jedes Taktsignal des Systems ein driveword ausgegeben werden, wodurch das redundante Speichern identischer gating-signal-Gruppen vermieden wird.

Die Offenlegungsschrift DE 196 20 207 A1 ist mit einer PWM-Schaltung (ist dasselbe wie eine PDM-Schaltung) für mehrere Kanäle befasst, bei der die Einschaltzeiten der einzelnen Kanäle zeitversetzt verteilt sind, um die bei gleichzeitigem Einschalten aller Kanäle auftretenden Instabiltäten zu vermeiden.

Ausgehend hiervon liegt der Erfindung die Aufgabe zugrunde, ein Karosseriesteuergerät anzugeben, dass die Steuerung von mehr Leuchtmitteln ermöglicht, als HW-PDM-Kanäle in dem Karosseriesteuergerät vorhanden sind.

Die Aufgabe wird gemäß den unabhängigen Ansprüchen der Erfindung gelöst.

Die Erfindung umfasst eine Vorrichtung gemäß Anspruch 1.

In diesem Zusammenhang wird darauf hingewiesen, dass die in dieser Beschreibung und den Ansprüchen zur Aufzählung von Merkmalen verwendeten Begriffe "umfassen", "aufweisen", "beinhalten", "enthalten" und "mit", sowie deren grammatikalische Abwandlungen, generell als nichtabschließende Aufzählung von Merkmalen, wie z.B. Verfahrensschritten, Einrichtungen, Bereichen, Größen und dergleichen aufzufassen ist, die in keiner Weise das Vorhandensein anderer oder zusätzlicher Merkmale oder Gruppierungen von anderen oder zusätzlichen Merkmalen ausschließt.

Die Erfindung umfasst ferner ein Verfahren gemäß Anspruch 7.

Die Erfindung ermöglicht eine elektromagnetisch verträgliche Ansteuerung pulsdauermoduliert steuerbarer elektrischer Verbraucher in Ergänzung oder als Alternative zur Steuerung mit HW-PDM-Kanälen einer Karosseriesteuerung.

Die Erfindung wird in ihren abhängigen Ansprüchen weitergebildet.

Zum leichten Abrufen und Sortieren der den pulsdauermodulierten Signalen zugeordneten Modulationsdaten sind diese in der Speichereinrichtung vorzugsweise in Listenform oder in Tabellenform gespeichert. Die Liste kann dabei aus in Tabellenform verwalteten Modulationsdaten vorteilhaft so erzeugt werden, dass die in der Tabelle enthaltenen Pulsanstiegs- und Pulsabfallzeitpunkte chronologisch sortiert in der Liste abgespeichert werden. Für die Umsetzung der in den Modulationsdaten auf einen Referenzzeitpunkt bezogenen Zeitpunkte ist die Steuersignalerzeugungseinrichtung zweckmäßig dazu ausgebildet, die in den Modulationsdaten gespeicherten Zeitpunkte zur Bildung der Steuersignale mit dem Signal eines Zeitgebers zu synchronisieren.

Um die Funktion des angesteuerten Elements zu prüfen, kann die Steuersignaleinrichtung ferner vorteilhaft dazu ausgebildet sein, zu einem bestimmten Zeitpunkt nach dem Pulsanstieg des Signals eines Signalübertragungskanals ein diesem Signal-übertragungskanal zugeordnetes Diagnosesignal abzufragen. Dieser bestimmte Zeitpunkt nach dem Pulsanstieg des Signals eines Signalübertragungskanals stimmt vorzugsweise mit dem Zeitpunkt des Pulsanstiegs des Signals des nachfolgenden Signalübertragungskanals überein.

Zur Verbesserung der elektromagnetischen Verträglichkeit der Steuerung fällt bevorzugt keiner der Zeitpunkte eines Pulsanstiegs des Signals eines Signalübertragungskanals mit dem Zeitpunkt eines Pulsanstiegs des Signals eines anderen Signalübertragungskanals zusammen. Um eine einfache Staffelung der Pulsanstiegszeiten zu erhalten, ist der Abstand des Zeitpunkts des Pulsanstiegs des Signals eines ersten Signalübertragungskanals zum Zeitpunkt des Pulsanstiegs des Signals eines nachfolgenden Signalübertragungskanals vorzugsweise konstant.

Weitere Merkmale der Erfindung ergeben sich aus der folgenden Beschreibung von Ausführungsbeispielen in Verbindung mit den Ansprüchen sowie den beiliegenden Figuren. Die einzelnen Merkmale können bei einer Ausführungsform gemäß der Erfindung je für sich oder zu mehreren verwirklicht sein. Bei der nachfolgenden Erläuterung einiger Ausführungsbeispiele der Erfindung wird auf die beiliegenden Figuren Bezug genommen, von denen
- Figur 1: ein Blockschaltbild einer elektronischen Steuereinrichtung mit einer Erweiterung der Kanäle zur pulsdauermodulierten Steuerung zeigt,
- Figur 2: ein Zeitdiagramm einer beispielhaften Pulsdauermodulierten von 8 Steuerkanälen zeigt, und
- Figur 3: in einem Flussdiagramm die grundlegenden Schritte eines von einer Steuereinrichtung nach Figur 1 durchgeführten Verfahrens veranschaulicht.

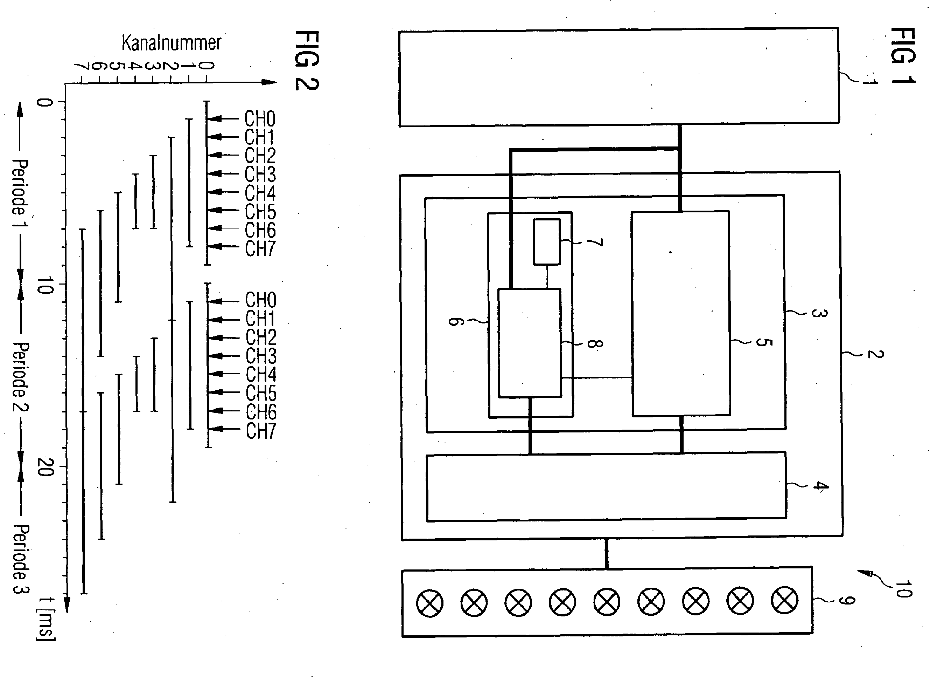

Figur 1 veranschaulicht in einem Blockschaltbild die wesentlichen Komponenten einer elektronischen pulsdauermodulierten Steuerung 10 von Licht emittierenden Einrichtungen in Kraftfahrzeugen. In der Figur sind nur die zum Verständnis der vorliegenden Erfindung erforderlichen Komponenten der Steuerung dargestellt. Auf die Darstellung weiterer, für den Betrieb der Steuervorrichtung erforderlicher oder deren weiteren Funktionsumfang bestimmender Komponenten wurde im Interesse einer übersichtlichen Darstellung verzichtet. Dennoch sind diese Komponenten als vorhanden angenommen.

Die Vielzahl von Licht emittierenden Einrichtungen bzw. Systemen 9 in Kraftfahrzeugen erfordert eine umfangreiche Steuerung dieser Systeme 9, die von einer elektronischen Steuereinrichtung 1 in Verbindung mit einer Karosseriesteuereinrichtung 2 pulsdauermoduliert vorgenommen wird. Für jede der Licht emittierenden Einrichtungen des Systems 9 ist eine eigene pulsdauermodulierte Versorgungsleitung erforderlich. Die Modulation erfolgt in der Regel mit einer Frequenz im Bereich von 100 bis 200Hz, wobei das Tastverhältnis bzw. der Füllgrad der Pulsdauermodulation den Mittelwert der Versorgungsgröße bestimmt. Üblicherweise wird als Versorgungsgröße die Versorgungsspannung gewählt. Je nach Art der Licht emittierenden Einrichtung kann aber auch der Versorgungsstrom die Versorgungsgröße bilden.

Füllgrad und Frequenz der pulsdauermodulierten Versorgung werden von der elektronischen Steuereinrichtung 1 entsprechend einem Fahrerwunsch oder bestimmten Systemanforderungen für jede der zu steuernden Licht emittierenden Einrichtungen vorgegeben und über die Verbindung 11 an die Logikuntereinheit 3 der zuständigen Karosseriesteuereinrichtung 2 übertragen. Die Logikuntereinheit 3 weist eine hardwarebasierte Steuereinheit 5 und eine softwarebasierte Steuereinheit 6 auf. Die hardwarebasierte Steuereinheit 5 enthält in der Regel eine MCU mit mehreren HW-PDM-Kanälen, die jeweils ein den Vorgaben der elektronischen Steuereinrichtung 1 entsprechendes pulsdauermoduliertes Steuersignal erzeugen können. Jedes dieser Steuersignale kann über eine Verbindung 12 an ein Stellelement einer Leistungsuntereinheit 4 übertragen werden, das die Versorgungsgröße des zu steuernden Licht emittierenden Elements dem Steuersignal entsprechend einstellt. Die Anzahl der in der hardwarebasierten Steuereinheit 5 vorhandenen HW-PDM-Kanäle reicht jedoch nicht zur Steuerung aller von der Karosseriesteuereinrichtung 2 zu versorgenden Licht- und Beleuchtungseinrichtungen.

In der Logikuntereinheit 3 ist daher die weitere Steuereinheit 6 vorgesehen, mit deren Hilfe die Anzahl der pulsdauermodulierten Steuerkanäle erweitert oder sogar komplett ersetzt werden kann, so dass die HW-PDM-Kanäle für andere Zwecke verwendet werden können. Die Steuereinheit 6 ist vorzugsweise in Form einer Datenverarbeitungseinrichtung mit einem Softwaretreiber ausgebildet, der die von der elektronischen Steuereinrichtung 1 über die Verbindung 11 empfangenen Vorgaben für Frequenz und Füllgrad eines jeden Ansteuerkanals in entsprechende pulsdauermodulierte Steuersignale für die Leistungsuntereinheit 4 umsetzt. Hierzu umfasst die Steuereinheit 6 einen Prozessor, der zur Ausführung eines entsprechenden Algorithmus ausgebildet ist. Dieser Algorithmus ist in einer Speichereinrichtung des Karosseriesteuergeräts 2 gespeichert und kann zur Ausführung von dem Prozessor aus diesem Speicher abgerufen werden. Diese Speichereinrichtung kann innerhalb der softwarebasierten Steuereinheit 6, z.B. in Form der Speichereinrichtung 7, aber auch außerhalb der Steuereinheit 6 angeordnet sein. Eine Erweiterung der bestehenden HW-PDM-Kanäle durch Software-PDM-Kanäle bietet sich an, wenn die zur Realisierung aller benötigten PDM-Kanäle erforderliche Prozessorleistung nicht vorhanden ist. Ansonsten wird der vollständige Ersatz der HW-PDM-Kanäle durch Software-PDM-Kanäle bevorzugt.

Die softwarebasierte Steuereinheit 6 weist eine Speichereinrichtung 7 und eine Steuersignalerzeugungseinrichtung 8 auf. Entsprechend den Vorgaben für Frequenz und Füllgrad berechnet die Steuersignalerzeugungseinrichtung 8 für jeden der von ihr betriebenen pulsdauermodulierten Steuerkanäle den Zeitpunkt des jeweiligen Pulsanstiegs und -abfalls. Diese Pulsflankenzeitpunkte sind auf einen Referenzzeitpunkt bezogen, der z.B. den Beginn einer von der Steuereinheit 6 durchgeführten Steuersequenz markieren kann. Die einzelnen Pulsflankenzeitpunkte sind als Modulationsdaten in dem Speicher 7 vorzugsweise in Listenform oder in tabellarischer Form und nach Steuerkanalnummer sortiert abgelegt. Durch Synchronisation des Referenzzeitpunkts mit einem in der Logikuntereinheit 3 verfügbaren oder dieser zugänglichen Taktsignal werden die Modulationsdaten in die aktuelle Zeit übertragen.

Zum Erzeugen der Steuersignale werden die Pulsflankenzeitpunkte für die benötigten Steuerkanäle von dem Speicher 7 abgerufen und mit einem von der hardwarebasierten Steuereinrichtung 5 bereitgestellten Takt- bzw. Zeitsignal synchronisiert. Das Diagramm der Figur 2 zeigt die Startsequenz einer pulsdauermodulierten Signalsteuerung mit 8 Kanälen. Die der Darstellung zugrunde liegende Frequenzvorgabe beträgt 100 Hz, d.h. die Startsequenz wiederholt sich mit einer Periodendauer von 10 Millisekunden. Die Füllgradvorgaben der einzelnen Steuerkanäle können der nachfolgenden Tabelle entnommen werden.

| **Bezeichnung des Steuerkanals** | **Kanalnummer** | **Füllgrad** |
|---|---|---|
| CH0 | 0 | 90% |
| CH1 | 1 | 70% |
| CH2 | 2 | 100% |
| CH3 | 3 | 40% |
| CH4 | 4 | 30% |
| CH5 | 5 | 60% |
| CH6 | 6 | 80% |
| CH7 | 7 | 100% |

Die Zeitpunkte der ansteigenden Pulsflanken sind, wie der Figur 2 zu entnehmen ist, von einem Kanal zum nächsten Kanal zeitlich versetzt angeordnet. In der dargestellten Ausführungsform ist der Zeitversatz zwischen benachbarten Kanälen, d.h. Kanälen mit aufeinander folgenden Kanalnummern, konstant und beträgt im vorgestellten Beispiel 1 ms. Bei Verwendung von mehr Steuerkanälen bei gleicher Frequenzvorgabe wird dieser Zeitversatz zweckmäßig verkürzt, bei Verwendung von beispielsweise 16 Kanälen auf 0,5 ms.

Durch das zeitlich versetzte Einschalten der an den Steuerkanälen angeschlossenen Verbraucher, die im Allgemeinen jedoch nicht notwendigerweise von Licht emittierenden Einrichtungen und Systemen des Fahrzeugs gebildet werden, wird die Belastungsänderung des Bordnetzes über einen größeren Zeitraum verteilt, so dass eventuell zu einer Funkstörung führende große Strom- oder Spannungsänderungen vermieden werden. Mithilfe des zeitlich versetzten Einschaltens der Verbraucher kann damit die elektromagnetische Verträglichkeit der Licht- und Beleuchtungssteuerung 10 sichergestellt werden.

Der Zeitpunkt der abfallenden Pulsflanke muss dabei nicht in derselben Steuersequenzperiode erfolgen, in der der Pulsanstieg bewirkt wurde. Abgesehen von der in Figur 2 dargestellten ersten Periode einer Steuersequenz, ist in jeder Periode sowohl die Pulsanstiegs- als auch die Pulsabfallflanke vorhanden, wenngleich sich abhängig vom Zeitpunkt der Pulsanstiegsflanke und der Dauer des Pulses die Reihenfolge von Pulsanstieg und Pulsabfall ändern kann. Durch den zeitlichen Versatz der Pulsanstiegsflanken der einzelnen Kanäle verschieben sich die Pulsabfallsflanken bei einigen Kanälen in die nachfolgende Steuersequenzperiode. In dem in Figur 2 gezeigten Beispiel erfolgt der Pulsanstieg des Steuersignals von Kanal CH0 mit Beginn der ersten Steuersequenzperiode zum Zeitpunkt 0. Der Pulsabfall dieses mit 90% Füllgrad vorgegebenen Signals erfolgt 9 ms später in derselben Periode. Der Abstand zum nachfolgenden Pulsanstieg des Signals für diesen Steuerkanal beträgt 1 ms. Anders bei den Steuerkanälen CH2, CH5, CH6 und CH7 mit den jeweiligen Kanalnummern 2, 5, 6 und 7. Diese beginnen zeitlich versetzt zum Signal des Kanals CH0 wie auch zueinander versetzt in der ersten Periode, enden jedoch erst in der darauf folgenden Periode 2; das Signal mit der Kanalnummer 5 beispielsweise bei 11 ms. Der Begriff eines Zeitpunkts von Pulsanstieg und Pulsabfall bzw. des Beginns oder Endes eines Steuersignals wird hierbei im logischen Sinn verwendet. Wie der Darstellung von Figur 2 entnommen werden kann, fallen bei den Steuersignalen der Kanäle 2 und 7 die dem jeweils ersten Pulsanstieg folgenden Pulsabfall- und - anstiegspaare zeitlich so zusammen, dass ein nicht unterbrochenes Dauersignal entsteht, also durch das Anfügen des Signalbeginns an das vorangehende Signalende kein von einem unmittelbar nachfolgenden Pulsanstieg begleiteter Pulsabfall bewirkt wird.

Die Zahl der von der Steuersignalerzeugungseinrichtung 8 handhabbaren pulsdauermodulierten Steuerkanäle unterliegt keiner prinzipiellen Begrenzung und bietet daher die Möglichkeit eine beliebige Anzahl von lichttechnischen Einrichtungen eines Kraftfahrzeugs zu steuern. Die Steuersignalerzeugungseinrichtung 8 kann daher zur Erweiterung der in der hardwarebasierten Steuereinrichtung 5 verfügbaren HW-PDM-Kanäle verwendet werden. Alternativ können sogar alle erforderlichen PDM-Steuerkanäle mittels der beschriebenen softwarebasierten Steuereinrichtung realisiert werden.

Zur Überprüfung der Ansteuerung der PDM-gesteuerten Verbraucher enthält die Leistungseinheit 4 Diagnoseeinrichtungen zum Erkennen von Fehlfunktionen, wie z.B. Kurzschlüssen oder Leitungsunterbrechungen, beispielsweise aufgrund einer ausgebrannten Lampe. Die Funktion oder Fehlfunktion eines Verbrauchers kann im Allgemeinen nur während der Versorgung des Verbrauchers mit Strom oder Spannung, d.h. während der Steuersignalpulse, festgestellt werden. Die Rückmeldung über das Vorhandensein oder Nichtvorhandensein einer Fehlfunktion, d.h. das Diagnosesignal, des angesteuerten Verbrauchers erfolgt jedoch zur Anstiegsflanke des Steuerpulses zeitlich versetzt. Die Verzögerung ist oft der erforderlichen Messzeit, die zum Beispiel durch die Zeit zum Wandeln einer analogen Größe in ein digitales Signal bestimmt sein kann, oder der Vermeidung von Überlagerungen der für die Steuerung des Systems erforderlichen Interrupts geschuldet.

Um den Verzögerungen Rechnung zu tragen, werden die einem Kanal zugeordneten Diagnosesignale erst einige Zeit nach dem Anstieg der Pulsflanke des Steuersignals dieses Kanals abgefragt. Die Abfrage kann in Form einer Anforderung oder eines einfachen Empfangs des Diagnosesignals bestehen. In der Darstellung der Figur 2 erfolgt das Abfragen des Diagnosesignals 1 ms nach dem Pulsanstieg des Steuersignals im zugeordneten Kanal und damit zum Zeitpunkt des Pulsanstiegs im nächstfolgenden Kanal. Dies ist jedoch nicht zwingend. Der Zeitversatz kann stattdessen auch unabhängig von der zeitlichen Verschiebung der Pulsanstiegsflanken der jeweils anderen Kanäle gewählt werden und auch von Kanal zu Kanal, beispielsweise infolge unterschiedlicher Diagnosezeiten, variieren. Hierzu sind jedoch mehr Interrupts erforderlich, als wenn wie in der Darstellung das Rücklesen der Diagnosesignale gleichzeitig mit dem Einschalten des nächsten Kanals erfolgt, so dass im Hinblick auf eine geringe Systembelastung das Rücklesen der Diagnosesignale bevorzugt synchron zum Einschalten des jeweils nachfolgenden Kanals erfolgt.

Auch wenn die Erfindung mit Bezug auf die pulsdauermodulierte Steuerung von lichttechnischen Einrichtungen eines Kraftfahrzeugs beschrieben wurde, kann die Erfindung auch zur Steuerung anderer Systeme oder Einrichtungen verwendet werden, die eine pulsdauermodulierte Steuerung gestatten.

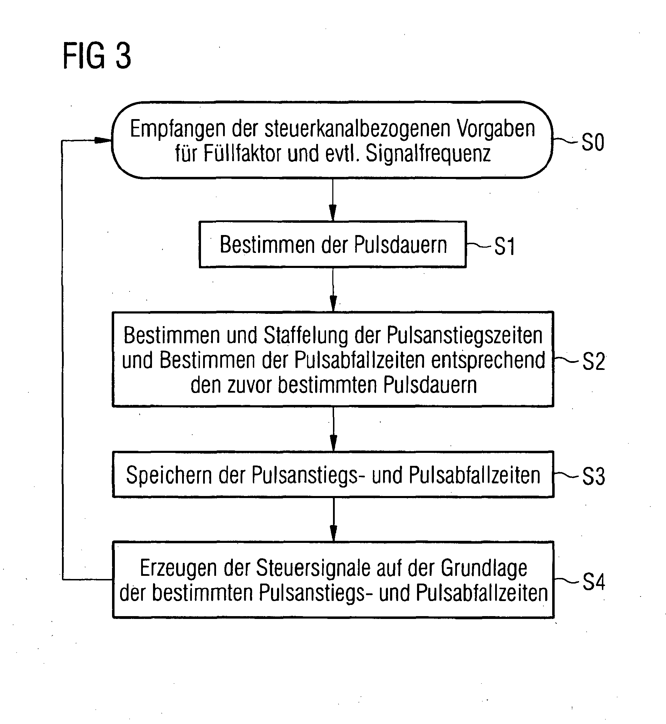

In der Figur 3 sind die grundlegenden Schritte des von der softwarebasierten Steuereinrichtung 6 der Vorrichtung 10 durchgeführten Verfahrens in einem Flussdiagramm dargestellt. Das Verfahren beginnt in Schritt S0 mit dem Empfang der von der zentralen elektronischen Steuereinrichtung 1 übertragenen Vorgaben für die Signalfrequenz und die Füllfaktoren für die einzelnen, von der Steuereinrichtung 6 zu erzeugenden PDM-Steuersignale durch die Steuersignalerzeugungseinrichtung 8 der softwarebasierten Steuereinrichtung 6. Die Vorgaben werden von der zentralen elektronischen Steuereinrichtung 1 übermittelt. Da die Signalfrequenz im Allgemeinen festgelegt ist, beispielsweise da die elektronische Steuereinrichtung 1, die die PDM-Steuersignale anfordert, üblicherweise in Einheit mit der softwarebasierten Steuereinrichtung 6 ausgeführt wird, kann ihre Übertragung entfallen, so dass die zentrale elektronische Steuereinrichtung 1 nur die Füllfaktoren für die Steuersignale der einzelnen Signalübertragungskanäle bzw. Steuerkanäle überträgt.

Im darauf folgenden Schritt S1 berechnet die Steuersignalerzeugungseinrichtung 8 für jeden der Signalübertragungskanäle die jeweilige Pulsdauer des in dem jeweiligen Signalübertragungskanal zu übertragenden Signals. Die jeweiligen Impulsdauern bzw. Pulsdauern der einzelnen Signalübertragungskanäle ergeben sich hierbei aus dem für jeden einzelnen der Signalübertragungskanäle vorgegebenen Füllfaktor und der Periodendauer eine Steuersequenz. Die Zeitpunkte der Pulsanstiegsflanken werden Schritt S2 von der Steuersignalerzeugungseinrichtung 8 entsprechend dem oben Beschrieben nach Kanalnummern gestaffelt, woraus sich in Verbindung mit den berechneten Pulsdauern die Zeitpunkte der Pulsabfallflanken für die einzelnen Kanäle ergeben. Pulsanstiegs- und Pulsabfallzeitpunkte werden von der Steuersignalerzeugungseinrichtung 8 chronologisch in einer Abfolge sortiert, so dass sich eine Liste oder Tabelle ergibt, die das Schaltverhalten von allen Kanälen zeitlich sortiert erfasst. Die so bestimmten Zeitpunkte der einzelnen Pulsanstiege und Pulsabfälle werden von der Steuersignalerzeugungseinrichtung 8 in Schritt S3 als Modulationsdaten in der Speichereinrichtung 7 gespeichert und in Schritt S4 von der Steuersignalerzeugungseinrichtung 8 zum Erzeugen der Steuersignale verwendet, die über eine Verbindung 13 an die Leistungsuntereinheit 4 weitergeleitet werden. Um auf Änderungen bezüglich der Füllfaktoren und eventuell der Signalfrequenz reagieren zu können, kehrt das in der softwarebasierten Steuereinrichtung 6 ablaufende Verfahren anschließend zu Schritt S0 zurück. Die Schritte S3 und S4 können auch in umgekehrter Reihenfolge oder gleichzeitig ausgeführt werden.

Kurz zusammengefasst überführt das von der Steuersignalerzeugungseinrichtung 8 der softwarebasierten Steuereinrichtung 6 ausgeführte Verfahren die von der zentralen elektronischen Steuereinrichtung 1 empfangenen Vorgaben für Füllfaktor und der Periodendauer in eine Bestimmung von Pulsanstiegszeit und Pulsabfallzeit, wobei diese Zeiten innerhalb einer Steuersequenzperiode definiert sind und die Pulsanstiegszeiten für Steuersignale verschiedener Signalübertragungskanäle zeitlich gestaffelt werden, so dass der Pulsanstieg nicht bei allen Steuersignalen gleichzeitig auftreten kann. Da, wenn die Vorgaben von der elektronischen Steuereinrichtung 1 nicht geändert werden, die Pulsanstiegszeiten und die Pulsabfallzeiten von Steuersequenzperiode zu Steuersequenzperiode gleich bleiben, genügt es, dass die Steuersignalerzeugungseinrichtung 8 die damit verbundenen Modulationsdaten in der Speichereinrichtung 7 chronologisch geordnet (z.B. in Tabellen- oder Listenform) ablegt und aus dieser bei der Erzeugung der Steuersignale periodisch ausliest. Damit setzt die Steuersignalerzeugungseinrichtung 8 die von der zentralen elektronischen Steuereinrichtung 1 empfangenen Vorgaben mit geringem technischem Aufwand in eine elektromagnetisch verträgliche pulsdauermodulierte Ansteuerung elektrischer Einrichtungen des Fahrzeugs um.

### Bezugszeichenliste

- 1: zentrale elektronische Steuereinrichtung
- 2: Karosseriesteuereinrichtung
- 3: Logikuntereinheit
- 4: Leistungsuntereinheit
- 5: hardwarebasierte Steuereinrichtung
- 6: softwarebasierte Steuereinrichtung
- 7: Speichereinrichtung
- 8: Steuersignalerzeugungseinrichtung (Treiber)
- 9: Lichtemittierende Einrichtungen und Systeme
- 10: Licht- und Beleuchtungssteuerung
- 11: Verbindung an Logikuntereinheiteinheit
- 12: Verbindung von hardwarebasierter Steuereinrichtung zur Leistungsuntereinheit
- 13: Verbindung von softwarebasierter Steuereinrichtung zur Leistungsuntereinheit
- CH0 - CH7: Steuerkanäle / Signalübertragungskanäle
- S0 bis S4: Verfahrensschritte

## Patentansprüche

1. Vorrichtung zum Erzeugen von pulsdauermodulierten Signalen für zumindest zwei Signalübertragungskanäle (CHO, ..., CH7) mit
- einer Steuersignalerzeugungseinrichtung (8) zum Erzeugen der pulsdauermodulierten Signale und
- einer Speichereinrichtung (7) zum Speichern von den pulsdauermodulierten Signalen zugeordneten Modulationsdaten,
wobei die Steuersignalerzeugungseinrichtung (8) ausgebildet ist,
- den Zeitpunkt des Pulsanstiegs und den Zeitpunkt des Pulsabfalls für jedes der über einen der Signalübertragungskanäle (CHO, ..., CH7)zu übertragenden pulsdauermodulierten Signale auf der Grundlage einer, auf jedes der pulsdauermodulierten Signale individualisierten, Vorgabe für Periodendauer und Füllgrad so zu bestimmen, dass sich zumindest der Zeitpunkt des Pulsanstiegs des pulsdauermodulierten Signals eines ersten Signalübertragungskanals (CHO, ..., CH7) von dem Zeitpunkt des Pulsanstiegs des pulsdauermodulierten Signals eines weiteren Signalübertragungskanals (CHO, ..., CH7) unterscheidet,
- die Zeitpunkte der Pulsanstiege und die Zeitpunkte der Pulsabfälle der pulsdauermodulierten Signale zusammen in einer zeitlichen Abfolge chronologisch anzuordnen und diese Zeitpunkte der Pulsanstiege und Pulsabfälle als Modulationsdaten in der Speichereinrichtung (7) zu speichern, und
- Pulsanstieg und Pulsabfall eines jeden der über einen der Signalübertragungskanäle (CHO, ..., CH7) übertragenen pulsdauermodulierten Signale entsprechend den in der Speichereinrichtung (7) gespeicherten Modulationsdaten zu erzeugen.

2. Vorrichtung nach Anspruch 1,
**dadurch gekennzeichnet,**
**dass** die den pulsdauermodulierten Signalen zugeordneten Modulationsdaten in der Speichereinrichtung (7) in Listenform gespeichert sind.

3. Vorrichtung nach Anspruch 1 oder 2,
**dadurch gekennzeichnet,**
**dass** die den pulsdauermodulierten Signalen zugeordneten Modulationsdaten in der Speichereinrichtung (7) in Tabellenform gespeichert sind.

4. Vorrichtung nach Anspruch 1, 2 oder 3".
**dadurch gekennzeichnet,**
**dass** die Steuersignalerzeugungseinrichtung (8) ausgebildet ist, zur Bildung der Steuersignale die in den Modulationsdaten gespeicherten Zeitpunkte mit dem Signal eines Zeitgebers zu synchronisieren.

5. Vorrichtung nach einem der vorangehenden Ansprüche,
**dadurch gekennzeichnet,**
**dass** die Steuersignaleinrichtung ausgebildet ist, zu einem bestimmten Zeitpunkt nach dem Pulsanstieg des Signals eines Signalübertragungskanals (CHO, ..., CH7) ein diesem Signalübertragungskanal zugeordnetes Diagnosesignal abzufragen.

6. Vorrichtung nach Anspruch 5,
**dadurch gekennzeichnet,**
**dass** der bestimmte Zeitpunkt nach dem Pulsanstieg des Signals eines Signalübertragungskanals (CHO, ..., CH6) mit dem Zeitpunkt des Pulsanstiegs des Signals des nachfolgenden Signalübertragungskanals (CH1, ..., CH7) übereinstimmt.

7. Verfahren zur Erzeugung von pulsdauermodulierten Signalen für zumindest zwei Signalübertragungskanäle (CHO, ..., CH7), mit
einem Schritt zum Empfangen eines Füllgrads des pulsdauermodulierten Signals für jeden der Signalübertragungskanäle (CHO, ..., CH7),
einem Schritt zur Bestimmung der einzelnen Pulsdauern der Signale für jeden der Signalübertragungskanäle (CHO, ..., CH7) auf der Grundlage der empfangenen Füllgrade,
einem Schritt zur Bestimmung der Zeitpunkte der Pulsanstiegsflanken und der Pulsabfallflanken der Signale eines jeden der Signalübertragungskanäle (CH0,...,CH7), so daß sich der Zeitpunkt des Pulsanstiegs des Signals eines ersten Signalübertragungskanals (CH0, ..., CH7) zumindest von dem Zeitpunkt des Pulsanstiegs des Signals eines weiteren Signalübertragungskanals (CH0, ..., CH7) unterscheidet,
einem Schritt zum chronologischen Anordnen der Zeitpunkte der Pulsanstiegsflanken und der Pulsabfallflanken der Signale eines jeden der Signalübertragungskanäle (CH0,...CH7), in einer zeitlichen Abfolge,
einem Schritt zum speichern dieser Zeitpunkte der Pulsanstiegsflanken und der Pulsabfallflanken, und einem Schritt zum Erzeugen der Pulsanstiegsflanken und Pulsabfallflanken eines jeden der über einen der Signalübertragungskanäle (CH0,...,CH7) übertragenen Signale entsprechend den gespeicherten Modulationsdaten.

8. Verfahren nach Anspruch 7,
**dadurch gekennzeichnet,**
**dass** kein Zeitpunkt des Pulsanstiegs des Signals eines Signalübertragungskanals (CH0, ..., CH7) mit dem Zeitpunkt des Pulsanstiegs des Signals eines anderen Signalübertragungskanals (CH0, ..., CH7) zusammenfällt.

9. Verfahren nach Anspruch 7 oder 8,
**dadurch gekennzeichnet,**
**dass** der Abstand des Zeitpunkts des Pulsanstiegs des Signals eines ersten Signalübertragungskanals (CH0, ..., CH6) zum Zeitpunkt des Pulsanstiegs des Signals eines nachfolgenden Signalübertragungskanals (CH1, ..., CH7) konstant ist.

## Claims

1. Apparatus for producing pulse-duration-modulated signals for at least two signal transmission channels (CHO, ..., CH7) having
- a control signal generation device (8) for producing the pulse-duration-modulated signals and
- a memory device (7) for storing modulation data associated with the pulse-duration-modulated signals,
wherein the control signal generation device (8) is designed
- to determine the instant of the pulse rise and the instant of the pulse fall for each of the pulse-duration-modulated signals to be transmitted via one of the signal transmission channels (CHO, ..., CH7) on the basis of a default for period duration and fill level, which default is individualized for each of the pulse-duration-modulated signals, such that at least the instant of the pulse rise in the pulse-duration-modulated signal on a first signal transmission channel (CHO, ..., CH7) differs from the instant of the pulse rise in the pulse-duration-modulated signal on a further signal transmission channel (CHO, ..., CH7),
- to chronologically arrange the instants of the pulse rises and the instants of the pulse falls in the pulse-duration-modulated signals together in a chronology and to store these instants of the pulse rises and pulse falls as modulation data in the memory device (7), and
- to produce a pulse rise and pulse fall for each of the pulse-duration-modulated signals transmitted via one of the signal transmission channels (CHO, ..., CH7) in accordance with the modulation data stored in the memory device (7).

2. Apparatus according to Claim 1,
**characterized**
**in that** the modulation data associated with the pulse-duration-modulated signals are stored in the memory device (7) in list form.

3. Apparatus according to Claim 1 or 2,
**characterized**
**in that** the modulation data associated with the pulse-duration-modulated signals are stored in the memory device (7) in table form.

4. Apparatus according to Claim 1, 2 or 3,
**characterized**
**in that** the control signal generation device (8) is designed to form the control signals by synchronizing the instants stored in the modulation data to the signal from a timer.

5. Apparatus according to one of the preceding claims,
**characterized**
**in that** the control signal device is designed to request, at a particular instant after the pulse rise in the signal on a signal transmission channel (CHO, ..., CH7), a diagnosis signal associated with said signal transmission channel.

6. Apparatus according to Claim 5,
**characterized**
**in that** the particular instant after the pulse rise in the signal on a signal transmission channel (CHO, ..., CH7) matches the instant of the pulse rise in the signal on the subsequent signal transmission channel (CH1, ..., CH7).

7. Method for producing pulse-duration-modulated signals for at least two signal transmission channels (CHO, ..., CH7), having
a step for receiving a fill level for the pulse-duration-modulated signal for each of the signal transmission channels (CH0, ..., CH7),
a step for determining the individual pulse durations of the signals for each of the signal transmission channels (CH0, ..., CH7) on the basis of the received fill levels,
a step for determining the instants of the pulse rising edges and the pulse falling edges of the signals on each of the signal transmission channels (CH0, ..., CH7), so that the instant of the pulse rise in the signal on a first signal transmission channel (CH0, ..., CH7) differs at least from the instant of the pulse rise in the signal on a further signal transmission channel (CH0, ..., CH7),
a step for chronologically arranging the instants of the pulse rising edges and the pulse falling edges of the signals on each of the signal transmission channels (CH0, ..., CH7) in a chronology,
a step for storing these instants of the pulse rising edges and the pulse falling edges,
and a step for producing the pulse rising edges and pulse falling edges of each of the signals transmitted via one of the signal transmission channels (CH0, ..., CH7) in accordance with the stored modulation data.

8. Method according to Claim 7,
**characterized**
**in that** no instant of the pulse rise in the signal on one signal transmission channel (CH0, ..., CH7) coincides with the instant of the pulse rise in the signal on another signal transmission channel (CH0, ..., CH7).

9. Method according to Claim 7 or 8,
**characterized**
**in that** the interval between the instant of the pulse rise in the signal on a first signal transmission channel (CHO, ..., CH7) and the instant of the pulse rise in the signal on a subsequent signal transmission channel (CH1, ..., CH7) is constant.

## Revendications

1. Dispositif permettant de générer des signaux avec modulation de largeur d'impulsion pour au moins deux canaux de transmission de signaux (CH0, ..., CH7), comportant
- un dispositif de production de signaux de commande (8) destiné à générer des signaux avec modulation de largeur d'impulsion, et
- un dispositif de stockage (7) pour mémoriser des données de modulation associées aux signaux avec modulation de largeur d'impulsion,
ledit dispositif de production de signaux de commande (8) étant configuré
- pour déterminer l'instant de la montée de l'impulsion et l'instant de la descente de l'impulsion pour chacun des signaux avec modulation de largeur d'impulsion à transmettre via l'un des canaux de transmission de signaux (CH0, ..., CH7), sur la base d'une référence, individualisée pour chacun des signaux avec modulation de largeur d'impulsion, à déterminer pour la durée de la période et le taux de remplissage, de telle sorte qu'au moins l'instant de la montée de l'impulsion du signal avec modulation de largeur d'impulsion d'un premier canal de transmission de signaux (CH0, ..., CH7) se différencie de l'instant de la montée de l'impulsion du signal avec modulation de largeur d'impulsion d'un autre canal de transmission de signaux (CH0, ..., CH7),
- pour ordonner chronologiquement les instants des montées d'impulsion et les instants des descentes d'impulsion des signaux avec modulation de largeur d'impulsion conjointement dans une suite chronologique et pour mémoriser ces instants des montées d'impulsion et des descentes d'impulsion en tant que données de modulation dans le dispositif de stockage (7), et
- pour générer la montée de l'impulsion et la descente de l'impulsion de chacun des signaux avec modulation de largeur d'impulsion transmis via l'un des canaux de transmission de signaux (CH0, ..., CH7) conformément aux données de modulation stockées dans le dispositif de stockage (7).

2. Dispositif selon la revendication 1, **caractérisé en ce que** les données de modulation associées aux signaux avec modulation de largeur d'impulsion sont stockées sous forme de liste dans le dispositif de stockage (7).

3. Dispositif selon la revendication 1 ou 2, **caractérisé en ce que** les données de modulation associées aux signaux avec modulation de largeur d'impulsion sont stockées sous forme de tableau dans le dispositif de stockage (7).

4. Dispositif selon la revendication 1, 2 ou 3, **caractérisé en ce que** le dispositif de production de signaux de commande (8) est configuré pour, en vue de la formation des signaux de commande, synchroniser avec le signal d'une horloge les instants stockés dans les données de modulation.

5. Dispositif selon l'une quelconque des revendications précédentes, **caractérisé en ce que** le dispositif de production de signaux de commande est configuré pour interroger, à un instant déterminé après la montée de l'impulsion du signal d'un canal de transmission de signaux (CH0, ..., CH7), un signal de diagnostic associé à ce canal de transmission de signaux.

6. Dispositif selon la revendication 5, **caractérisé en ce que** l'instant déterminé après la montée de l'impulsion du signal d'un canal de transmission de signaux (CH0, ..., CH6) coïncide avec l'instant de la montée de l'impulsion du signal du canal de transmission de signaux (CH0, ..., CH7) consécutif.

7. Procédé permettant de générer des signaux avec modulation de largeur d'impulsion pour au moins deux canaux de transmission de signaux (CH0, ..., CH7), comportant une étape pour recevoir un taux de remplissage du signal avec modulation de largeur d'impulsion pour chacun des canaux de transmission de signaux (CH0, ..., CH7),
une étape pour déterminer les différentes durées d'impulsion des signaux pour chacun des canaux de transmission de signaux (CH0, ..., CH7) sur la base des taux de remplissage reçus,
une étape pour déterminer les instants des fronts de montée de l'impulsion et des fronts de descente de l'impulsion des signaux de chacun des canaux de transmission de signaux (CH0, ..., CH7), de telle sorte que l'instant de la montée de l'impulsion du signal d'un premier canal de transmission de signaux (CH0, ..., CH7) se différencie au moins de l'instant de la montée de l'impulsion du signal d'un autre canal de transmission de signaux (CH0, ..., CH7),
une étape pour ordonner chronologiquement dans une suite chronologique les instants des fronts de montée de l'impulsion et des fronts de descente de l'impulsion des signaux de chacun des canaux de transmission de signaux (CH0, ..., CH7),
une étape pour mémoriser ces instants des fronts de montée de l'impulsion et des fronts de descente de l'impulsion, et
une étape pour générer les fronts de montée de l'impulsion et les fronts de descente de l'impulsion de chacun des signaux transmis via l'un des canaux de transmission de signaux (CH0, ..., CH7), conformément aux données de modulation stockées.

8. Procédé selon la revendication 7, **caractérisé en ce qu'**aucun instant de la montée de l'impulsion du signal d'un canal de transmission de signaux (CH0, ..., CH7) ne coïncide avec l'instant de la montée de l'impulsion d'un autre canal de transmission de signaux (CH0, ..., CH7).

9. Procédé selon la revendication 7 ou 8, **caractérisé en ce que** la distance entre l'instant de la montée de l'impulsion du signal d'un premier canal de transmission de signaux (CH0, ..., CH7) et l'instant de la montée de l'impulsion du signal d'un autre canal de transmission de signaux (CH0, ..., CH7) consécutif est constante.
